# EUROPEAN PATENT APPLICATION

(11) **EP 1 720 201 A1**
(43) Date of publication of application: **08.11.2006**
(21) Application number: 05719630.5
(22) Date of filing: 28.02.2005
(51) Int. Cl.: H01L 21/301, B81C 1/00, G01D 5/24, G01P 15/125, H01L 29/84

(54) **SEMICONDUCTOR DEVICE**

(30) Priority: 27.02.2004 JP 2004054711; 31.05.2004 JP 2004160631
(71) Applicant: TOKYO ELECTRON LIMITED, Minato-ku, Tokyo 107-8481 (JP)
(72) Inventor: KAGAWA, Kenichi, c/o TOKYO ELECTRON AT LIMITED, Amagasaki City, Hyogo 6600891 (JP); YAKABE, Masami, c/o TOKYO ELECTRON AT LIMITED, Amagasaki City, Hyogo 6600891 (JP)
(74) Representative: Liesegang, Eva
(86) International application number: PCT/JP2005/003302
(87) International publication number: WO 2005/083765

(57) **Abstract**

In a semiconductor device a substrate is formed in a rectangular shape having four edges along dicing lines, and a jetty portion is formed so as to surround an actuator element and an electrode pad for signal input and output. The jetty portion is a rectangular shape having four sides and each side continuously extends along each edge of the substrate in parallel. A foreign object generated when dicing process is performed, is prevented from attaching onto the actuator element and the electrode pad because close adhesion of a protecting tape is improved by the jetty portion.

## Description

### TECHNICAL FIELD

The present invention relates to a semiconductor device, and more particularly, to a semiconductor device which is cut into respective chips by a dicing process.

### BACKGROUND ART

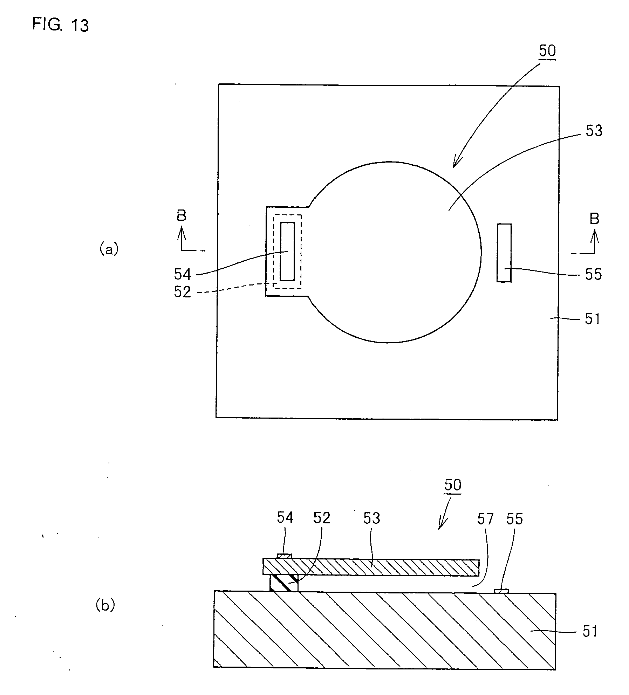

Fig. 13 (A) and Fig. 13 (B) are diagrams to show an actuator element, and Fig. 13 (A) is a plan view and Fig. 13 (B) is a cross sectional view when cut along a line B - B shown in Fig. 13 (A).

In Fig. 13, the actuator element 50 has a laminated structure including a substrate 51, a fixing portion 52, a conducting layer 53 and electrode pads 54, 55. The conducting layer 53 is formed in a circular shape and supported with a cantilever type supporting form by the fixing portion 52 so as to make a space 57 between the substrate 51 and the conducting layer 53. The conducting layer 53 moves upward or downward at the fixing portion 52 as a fulcrum in response to an electric signal which is input to the electrode pads.

The actuator element 50 shown in Fig. 13 is fabricated in a manner that after a plurality of the actuator elements are formed on a silicon wafer 103 as the substrate 51, each element is cut out into a semiconductor chip utilizing the dicing technology as shown in Fig. 14, then, lead frames are connected and the semiconductor chip is packaged. The dicing process is performed in a manner that the silicon wafer 103 is cut by a high speed revolving blade 101 on which diamond powder is dusted while washing water 102 is sparged as shown in the perspective view of Fig. 14 and in the cross sectional view of Fig. 15. At this point, a foreign object 104 such as chippage is flying off while the silicon wafer 103 is cut.

When the above described foreign object 104 attaches on the conducting layer 53 in the cutting process for the actuator element 50 to form the objective chips, it causes a problem that operation of the element is impaired. Therefore, it is required to prevent the foreign object 104 from attaching on the conducting layer 53. For this purpose, it is effective that amount of the washing water 102 is increased during the dicing process. There may be, however, a possibility of causing a breakage of the conducting layer 53 by a physical external force which is given onto the conducting layer 53 by the washing water 102 when amount of the washing water is increased.

To avoid this, the dicing process is performed while a surface of the actuator element 50 is protected by a protecting tape 9 for surface protection which is adhered on the conducting layer 53 of each actuator element 50 as shown in Fig. 16.

However, depending on a shape of the conducting layer 53, because there are portions with wide space and portions with narrow space between two adjoining elements when look down from above, the fact causes to arise portions with better adhesion and portions with worse adhesion of the protecting tape 9. In response to the wide space and the narrow space, it is different in manner how the action of force works on the protecting tape 9 when the dicing process is performed with the blade 101. Because of this, a raise and a peeling of the protecting tape 9 are caused while the dicing process is performed. As a result of this, the washing water 102 containing the foreign object 104 gets into inside of the actuator element 50 from raised portions and peeled portions of the protecting tape 9, and the foreign object 104 attaches on the conducting layer 53 or the structure body in the actuator element 50 breaks.

In Japanese Unexamined Patent Publication No. 06-347475, a method is disclosed to prevent interfusion and invasion of the dust, the chippage and the water into the fixing portion and the movable portion by covering the fixing portion and the movable portion formed on the substrate when the dicing of the substrate is performed in an acceleration sensor.

In the acceleration sensor disclosed in the Japanese Unexamined Patent Publication No. 06-347475, because the fixed electrode is covered and wire bonding to the fixed electrode cannot be performed, the electrode pads for signal input and output are formed outside of the cover, and the fixed electrode and the electrode pad are connected by an extended electrode.
As a result, though the fixed electrode and the movable electrode can be protected by the covering, because the electrode pads are exposed, there may be a possibility of causing a breaking wire on the electrode pads by giving an incised cut when the substrate is cut.

Moreover, when the dust or the chippage attaches to the electrode pad, there may be a possibility of causing increasing in resistance value for suffering bonding or to cause decreasing in reliability. Further, there may be a possibility of causing a problem that adhesion force of the bonding becomes decreased when water is splashed on the electrode pads and metal material changes in its quality.

### DISCLOSURE OF THE INVENTION

As a result, it is an object of the present invention to provide a semiconductor device in which the chips can be cut stably without the raise or the peeling of the protecting tape when the dicing process is performed.

Moreover, it is another object of the present invention to provide a semiconductor device in which the foreign object such as the chippage does not intrude and the breakage of the structure body would not happen.

In accordance with one aspect of the present invention, a semiconductor device cut into respective chips by a dicing process, includes: a substrate having an edge along dicing line; a semiconductor element formed on the substrate; a jetty portion formed between the semiconductor element and the edges on the substrate; and an electrode pad for signal input and output which is formed on the substrate, and inside of the outermost wall of the jetty portion.

As a result, the chips can be cut stably without the raise or the peeling of the protecting tape when the dicing process is performed to cut the portion because the protecting tape is stably supported by the adjoining jetty portions. Moreover, because the electrode pads are formed inside of the outermost wall surface of the jetty portion, the possibility is cleared that the electrode pad is damaged and broken when the dicing process is performed, and that the dust and the chippage do not attach to the electrode pad for signal input and output. Further, it can be prevented that adhesion force of bonding becomes decreased when water is splashed on the electrode pad, and the metal material changes in its quality.

Preferably, the jetty portion continuously extends along the edge in parallel. By this arrangement, the dicing process can be stably performed along the jetty portion.

Preferably, the jetty portion is formed so as to surround the whole periphery of the semiconductor element. By forming of such jetty portion, because the foreign object is blocked by the jetty portion even when the foreign object generated by the dicing process intrudes under the protecting tape, it can be prevented that the foreign object intrudes inside of the semiconductor element.

Preferably, the semiconductor element includes an insulating layer and a conducting layer formed on the insulating layer, the jetty portion includes an insulating layer and a conducting layer formed on the insulating layer, the insulating layer of the semiconductor element and the insulating layer of the jetty portion are formed in the same process, and the conducting layer of the semiconductor element and the conducting layer of the jetty portion are formed in the same process. Because they are formed in the same process as above described, new process is not required and increase of cost for arranging the jetty portion can be prevented.

Preferably, the electrode pad for signal input and output is formed on the conducting layer of the semiconductor element and the semiconductor device further includes an electrode pad for the jetty portion which is formed inside of the outermost wall on the conducting layer of the jetty portion, and which is connected electrically to the electrode pad for signal input and output in order to make potential difference between the conducting layer of the jetty portion and the conducting layer of the semiconductor element close to zero.

Because the potential difference between the conducting layer of the jetty portion and the conducting layer of the semiconductor element is made close to zero, adverse effect caused by the parasitic capacity generated between both conducting layers can be prevented. Moreover, it becomes possible to remove effect by the electrostatic attraction.

In accordance with another aspect of the present invention, a semiconductor device includes: a substrate; a structure body supported by a fixing portion so as to form a space between the substrate and the structure body; and a jetty portion formed on the substrate between the outer periphery of the substrate and a portion of the structure body which is not supported by the fixing portion.

Because the jetty portion is arranged in a space between the substrate and the structure body, which becomes a passage of intruding of the foreign object, it can be prevented that the foreign object intrudes.

Preferably, a plurality of the jetty portions are formed so as to surround the outer periphery of the structure body. By this arrangement, the foreign object would not intrude into the semiconductor element from any direction.

Preferably, the semiconductor device further includes an electrode pad for signal input and output which is formed on the structure body and inside of the outermost wall of the jetty portion. Because the electrode pad for signal input and output is formed inside of the outermost wall of the jetty portion, it can be prevented that the electrode pad for signal input and output is damaged when the dicing process is performed for the substrate.

Preferably, a plurality of the jetty portions are formed so as to surround the structure body and the electrode pad for signal input and output is arranged inside of an imaginary outer periphery which is formed by connecting the outermost walls of the jetty portions. By this arrangement, it can be prevented that the electrode for signal input and output on the jetty portion is damaged when the dicing process is performed for the substrate.

Preferably, the structure body includes a conducting layer formed on the fixing portion; the jetty portion includes an insulating layer and a conducting layer formed on the insulating layer; the fixing portion of the structure body and the insulating layer of the jetty portion are formed in the same process; and the conducting layer of the structure body and the conducting layer of the jetty portion are formed in the same process. Because they are formed in the same process as described above, no new process is required, and increase of cost by arranging the jetty portion can be prevented.

The electrode pad for signal input and output is formed on the conducting layer of the structure body and the semiconductor device further includes an electrode pad for the jetty portion which is formed on the conducting layer of the jetty portion, and which is connected electrically to the electrode pad for signal input and output in order to make potential difference between the conducting layer of the jetty portion and the conducting layer of the structure body close to zero.

Because the potential difference between the conducting layer of the jetty portion and the conducting layer of the structure body is made close to zero, the adverse effect caused by the parasitic capacity generated between the both conducting layers can be prevented.

Preferably, the semiconductor device further includes a potential equalizer in order to make the potential difference between the conducting layer of the jetty portion and the conducting layer of the structure body close to zero. Because the potential difference between the both conducting layers is made close to zero, and the parasitic capacity generated between the both conducting layers does not function as a capacitor, the adverse effect caused by the parasitic capacity can be prevented.

Preferably, the semiconductor device further includes an impedance detector which is connected to the electrode pad for signal input and output to detect impedance change between the structure body and the substrate. Because the impedance change between the structure body and the substrate is detected, the semiconductor device can be utilized as a capacity type detecting sensor.

Preferably, an upper portion of inside area of the jetty portion is opened. Because the upper portion of the inside area of the jetty portion is opened though the jetty portion is formed, wire-bonding for the respective electrodes can be easily performed.

### BRIEF DESCRIPTION OF DRAWINGS

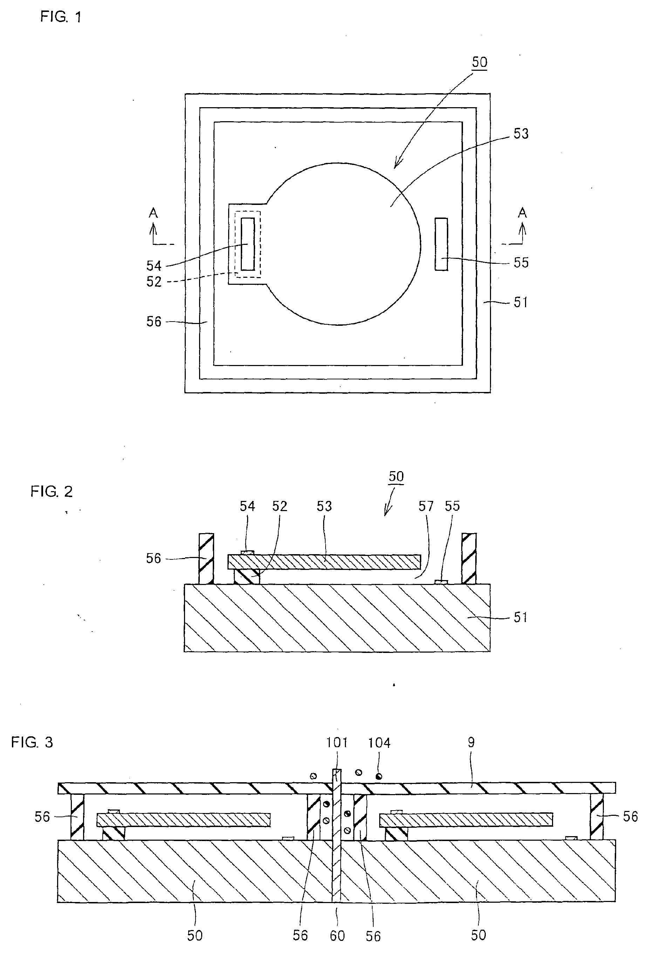

Fig. 1 is a plan view to show a semiconductor device according to a first embodiment of the present invention;
Fig. 2 is a cross sectional view to show the semiconductor device when cut along the line A - A shown in Fig. 1;
Fig. 3 is a cross sectional view to show a state that a dicing process is performed for a silicon wafer on which a plurality of semiconductor devices shown in Fig. 1 are formed;

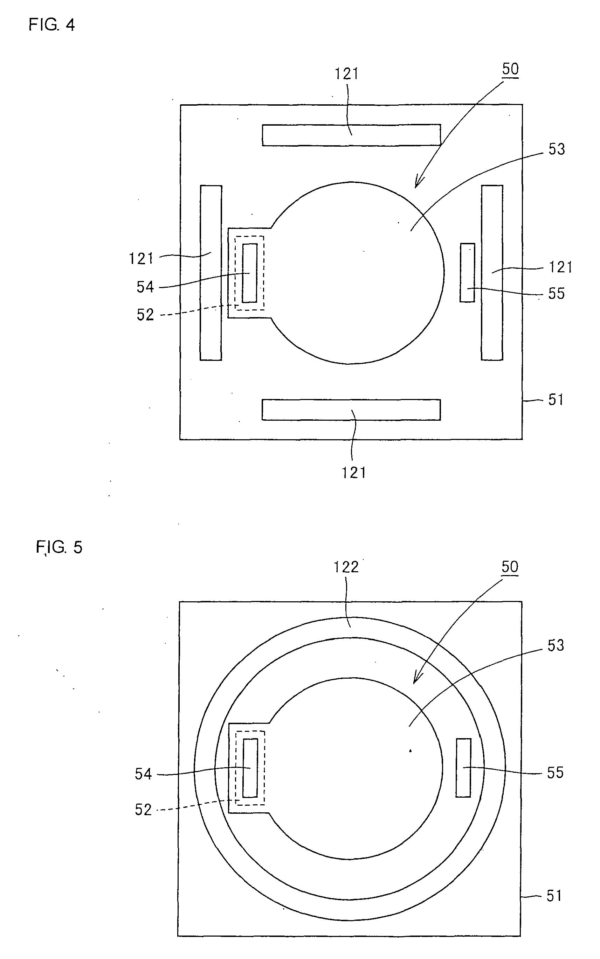

Fig. 4 is a plan view to show a semiconductor device according to a second embodiment of the present invention;
Fig. 5 is a plan view to show a semiconductor device according to a third embodiment of the present invention;

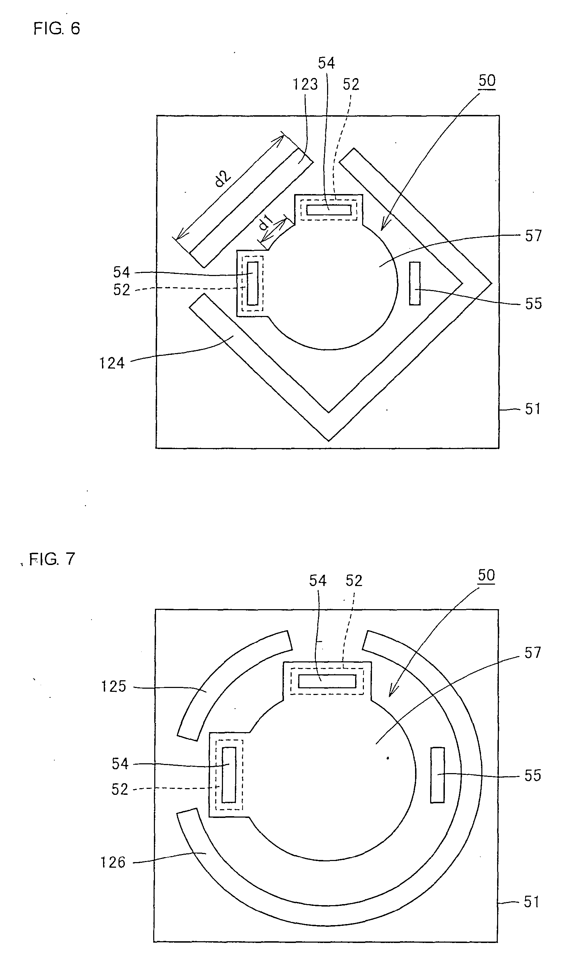

Fig. 6 is a plan view to show a semiconductor device according to a fourth embodiment of the present invention;
Fig. 7 is a plan view to show a semiconductor device according to a fifth embodiment of the present invention;

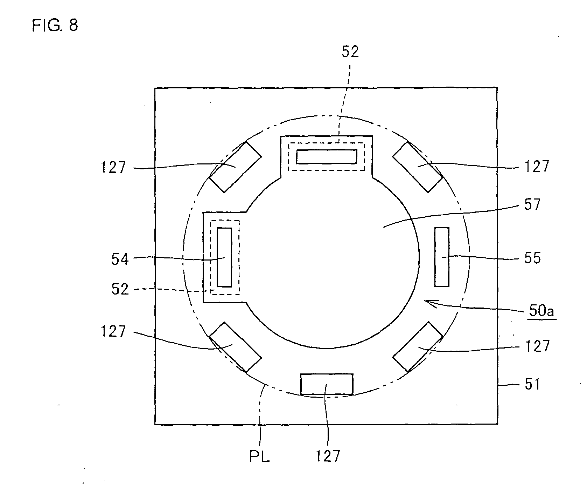

Fig. 8 is a plan view to show a semiconductor device according to a sixth embodiment of the present invention;

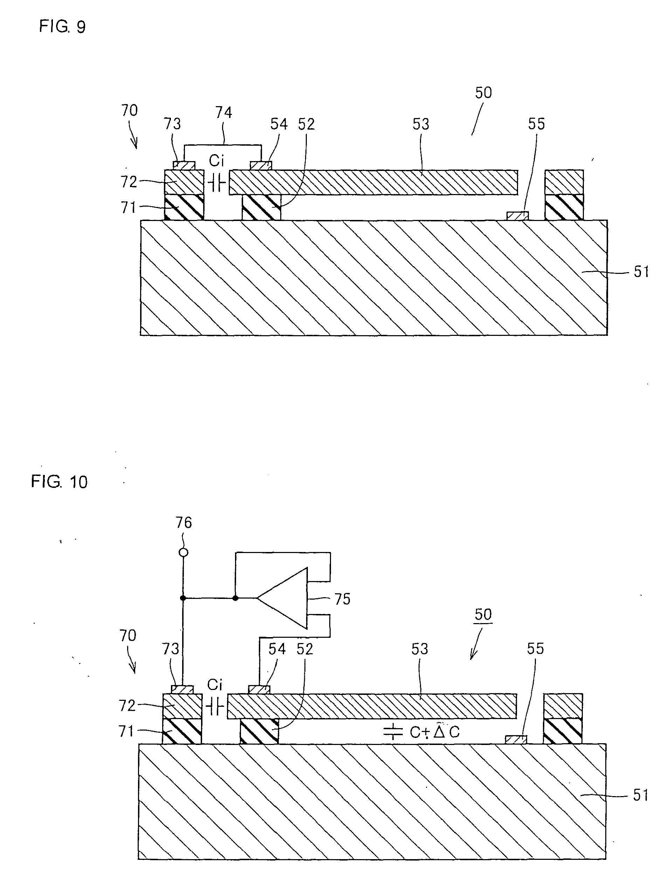

Fig. 9 is a cross sectional view to show a semiconductor device according to a seventh embodiment of the present invention;
Fig. 10 is a cross sectional view to show a semiconductor device according to an eighth embodiment of the present invention;

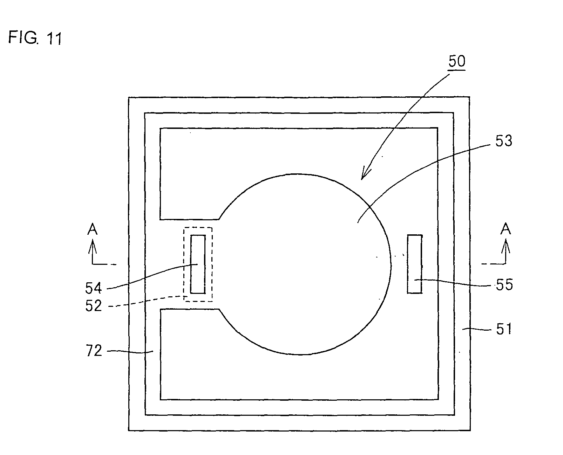

Fig. 11 is a plan view to show a semiconductor device according to a ninth embodiment of the present invention;

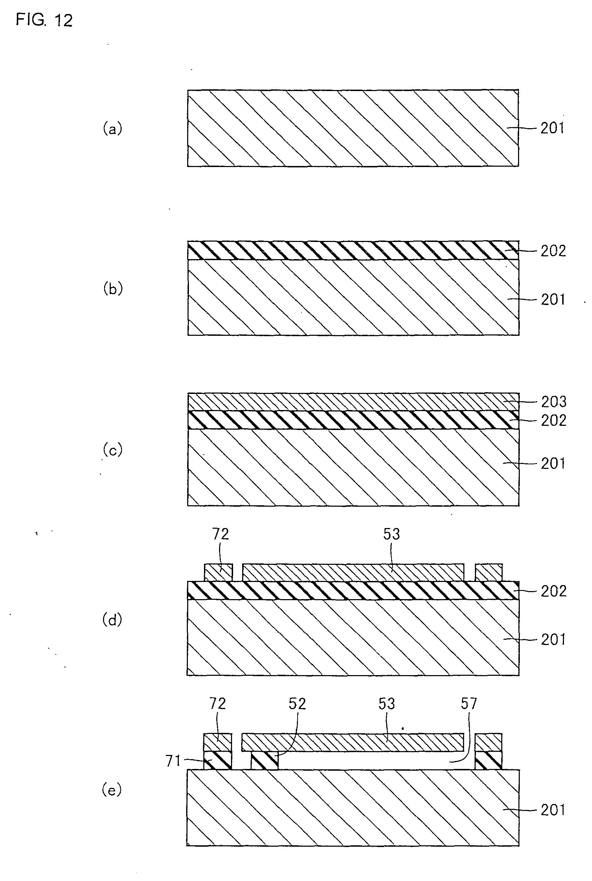

Fig. 12 are diagrams to sequentially show the manufacturing process for the semiconductor devices shown in Fig. 9 and Fig. 10;
Fig. 13 are diagrams to show an actuator element in prior art technology;

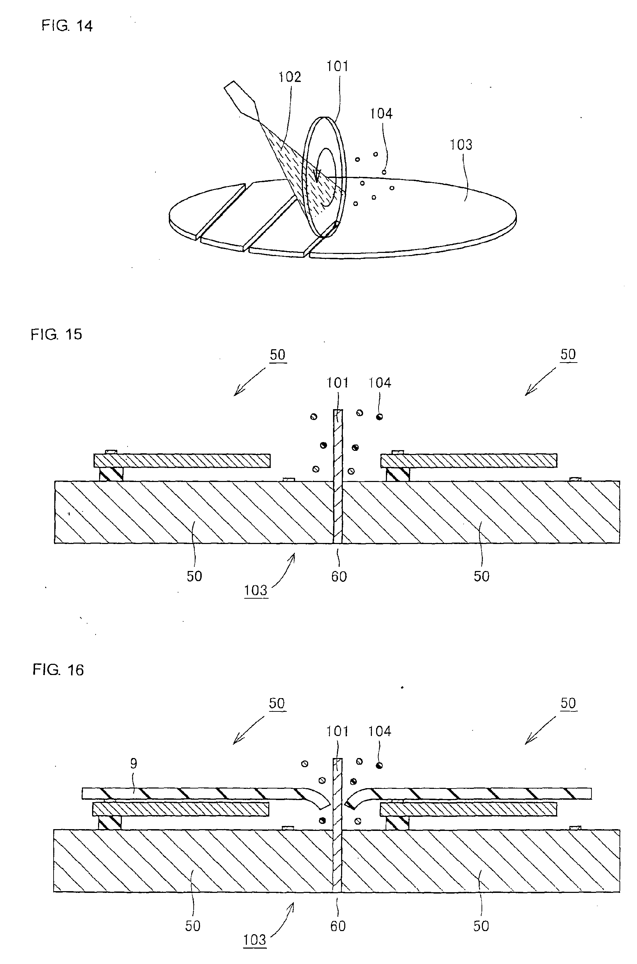

Fig. 14 is a diagram to show a dicing process in the prior art technology;
Fig. 15 is a cross sectional view to show the dicing process in the prior art technology by which the dicing is performed on a silicon wafer; and
Fig. 16 is a cross sectional view to show the dicing process in the prior art technology by which the dicing is performed on a silicon wafer in a state that surface of the element is covered by a protecting tape.

### BEST MODE FOR CARRYING OUT THE INVENTION

Fig. 1 is a plan view to show a semiconductor device according to a first embodiment of the present invention and Fig. 2 is a cross sectional view to show the semiconductor device when cut along the line A - A shown in Fig. 1.

In Fig 1, an actuator element 50 which constitutes a semiconductor device, has a laminated structure including a substrate 51, a fixing portion 52, and a conducting layer 53 as a structure body, electrode pads 54, 55 for signal input and output and a jetty portion 56. The conducting layer 53 is formed in a circular shape and supported with a cantilever type supporting form by the fixing portion 52 so as to make a space 57 between the substrate 51 and the conducting layer 53. The conducting layer 53 moves upward or downward at the fixing portion 52 as a fulcrum, in response to an electric signal which is input to the electrode pads 54, 55. At this point, an insulating layer or a semiconductor layer as the structure body may be utilized instead of the conducting layer 53.

The substrate 51 is formed in a rectangular shape which has four edges along dicing lines and the jetty portion 56 is formed so as to locate between the actuator element 50 and the respective edges of the substrate 51 and to surround the actuator element 50. The jetty portion 56 has a rectangular shape with four sides and each side continuously extends in parallel along each edge of the substrate 51. Moreover, the jetty portion 56 is formed such that height of the jetty portion becomes higher than that of a top surface of the conducting layer 53. On the conducting layer 53, the electrode pad 54 is formed, and on the substrate 51, the electrode pad 55 is formed. It is preferable that the jetty portion 56 surrounds whole periphery of the actuator element 50.

By this reason, the respective electrode pads 54, 55 are formed within the jetty portion 56. Because the electrode pads 54, 55 are wire-bonded after the dicing process, no lid is arranged on the jetty portion 56 and the upper portion thereof is wide open.

At this point, the jetty portion 56 can be formed out of the same material and in the same process as the fixing portion 52 is formed.

Fig. 3 is a cross sectional view to schematically show a state that the dicing process is performed for a silicon wafer 60 on which a plurality of actuator elements 50 shown in Fig. 1 are formed. On the silicon wafer 60, a plurality of the actuator elements 50 having the laminated structure which is explained with Fig. 1, are formed and a protecting tape 9 is adhered with close contact on the jetty portion 56. Further, the dicing process is performed for the silicon wafer 60 to cut off each semiconductor chip along edges of the substrate 51 by a blade 101 so as to be guided between the adjoining jetty portions 56, 56 of the actuator elements 50.

Because any step portion is not generated and a distance between the jetty portions 56, 56 of respective actuator elements 50 can be made equal, force acting on the protecting tape 9 can be made uniform when the dicing process is performed along the dicing lines by the blade 101. By this arrangement, the raise or the peeling of the protecting tape 9 would not happen. Moreover, even when the washing water containing the foreign object 104 leaks down from a cut portion of the protecting tape 9, because the water stays between the adjoining jetty portions 56, 56, it would not happen that the foreign object 104 intrudes into inside of the actuator element 50 and it can be prevented that the breakage of the structure body in the actuator element 50 is caused.

Moreover, because all the electrode pads 54, 55 are located inside of the outermost wall surface of the jetty portion 56, the possibility is cleared that the electrode pads are damaged and broken by the blade 101 when the dicing process is performed. The dust and the chippage do not attach to the electrode pads 54, 55 within the jetty portion 56 because the protecting tape 9 is adhered on the jetty portion 56. As a result, the possibilities are cleared that value of the resistance becomes high, the bonding is suffered and the reliability is decreased by attaching of the dust and the chippage to the electrode 54, 55, and also a problem is not caused that the adhesion force of the bonding becomes decreased when the water is splashed on the electrode pads 54, 55, and the metal material changes in its quality.

Because no lid is arranged on the area within the jetty portion 56, the jetty portion 56 is wide opened and finally the protecting tape is took away, there will be no trouble when wire-bonding is performed for the electrode pads 54, 55 after the dicing process is performed.

At this point, in the embodiment shown in Fig. 1, though the rectangular shaped jetty portion 56 is formed so as to surround periphery of the actuator element 50, the embodiment should not be considered as a restricted example, and the jetty portion 56 may be formed at any portion on the substrate 51 between a portion of the conducting layer 53 which is not supported by the fixing portion 52 and the outer periphery of the substrate 51. In other words, the jetty portion 56 may be formed such that the foreign object 104 cannot invade from a portion where the fixing portion 52 is not formed because the fixing portion 52 itself can prevent an invasion of the foreign object 104.

Fig. 4 is a plan view to show a semiconductor device according to a second embodiment of the present invention. In the embodiment shown in Fig. 4, four jetty portions 121 which are independent and parallel to the four edges of the substrate 51 without surrounding whole periphery of the actuator element 50, are formed between the actuator element 50 and the respective edges of the substrate.

As above described, only by forming the jetty portions 121 parallel to the respective edges of the substrate 51 without surrounding whole periphery of the actuator element 50, the close adhesion of the protecting tape 9 shown in Fig. 3, can be improved by the jetty portions 121, and the force acting on the protecting tape 9 can be made uniform when the dicing process is performed by the blade 101 for the silicon wafer. Further, a load applied on the actuator element 50 when the protecting tape is adhered, can be reduced.

Moreover, even in this embodiment because the electrode pads 54, 55 are arranged inside of the jetty portions 121, the possibilities are cleared that the electrode pads 54, 55 are damaged and broken by the blade 101 when the dicing process is performed and that the foreign object 104 attaches.

Fig. 5 is a plan view to show a semiconductor device according to a third embodiment of the present invention. In this third embodiment shown in Fig. 5, the jetty portion 122 is configured to have a circular shape so as to surround the electrode pads 54, 55 and the whole periphery of the actuator element 50. By this arrangement even when the cutting portion of the protecting tape 9 shown in Fig. 3, hangs down and the washing water containing the foreign object 104 leaks downward from the cutting portion of the protecting tape 9, the foreign object 104 does not intrude inside of the actuator element 50 because the water stays between the adjoining jetty portions 122, 122.

As a result, it can be prevented that the breakage of the structure body in the actuator element 50 is caused by the degradation of the protection ability. Further, it would not happen that the electrode pads 54, 55 are damaged and the foreign object 104 attaches.

At this point, the present invention should not be restricted only to the jetty portion 56 in the rectangular shape shown in Fig. 1 or to the jetty portion 122 in the circular shape shown in Fig. 5, and the shape of the jetty portion may be modified. After all, any shape can be applied as far as the shape surrounds the periphery of the actuator element 50.

Fig. 6 is a plan view to show a semiconductor device according to a fourth embodiment of the present invention. In the embodiment shown in Fig. 5, the jetty portion 122 is formed to surround the periphery of the actuator element 50 and the electrode pads 54, 55, on the contrary, in this embodiment shown in Fig. 6, the semiconductor device is configured such that two fixing portions 52 are arranged on two portions of the substrate 51 and that the conducting layer 57 is supported by these fixing portions 52. In order to avoid the invasion of the foreign object from a gap portion arranged between the respective fixing portions 52, 52, a jetty portion 123 which has a longer length d2 than a width d1 of a narrower side of the gap portion, is arranged between the actuator element 50 and the outer periphery of the substrate 51. A jetty portion 124 is configured to have U shape so as to surround a wider gap portion except the gap portion having width d1.

As above described, by arranging the jetty portions 123, 124 opposedly to the gap portions which are formed between the fixing portions 52, it can be prevented that the foreign object 104 intrudes into the space between the substrate 51 and the conducting layer 57 of the actuator element 50.

Fig. 7 is a plan view to show a semiconductor device according to a fifth embodiment of the present invention. In this embodiment, a jetty portion 125 which is formed in a short circular arc and a jetty portion 126 which is formed in a long circular arc are disposed opposedly to the gap portions formed between the fixing portions 52 instead of the jetty portions 123, 124 shown in Fig. 6. Even by arranging the jetty portions 125, 126 of such kind, it can be prevented that the foreign object 104 intrudes into space of the actuator element 50.

Fig. 8 is a plan view to show a semiconductor device according to a sixth embodiment of the present invention. In this embodiment, the semiconductor device is configured such that a plurality of jetty portions 127 which have a shorter length than the width d1 of the gap portion, are closely located opposedly to the respective gap portions which are formed between the fixing portions 52, 52. Though the length of the jetty portion 127 is shorter than the width d1 of the gap portion, the jetty portion can prevent the foreign object 104 from intruding into the space of the actuator element 50 because the jetty portions are closely located to the space.

At this point in Fig. 8, both of the electrode pads 54 which are formed on the conducting layer 57, and the electrode pad 55 which is formed on the substrate 51, are arranged inside of an imaginary outer periphery PL which is formed by connecting the outermost walls of the jetty portions 127. As described above, because the electrode pads 54, 55 are located inside of the outer walls of the jetty portions 127, the possibilities are cleared that the electrode pads 54, 55 are damaged and broken by the blade 101 when the dicing process is performed.

Fig. 9 is a cross sectional view to show a semiconductor device according to a seventh embodiment of the present invention.

In the semiconductor device shown in Fig. 1 described above, because of forming the jetty portion 56, there is a possibility that parasitic capacity Ci is generated between the jetty portion 56 and a side surface of the conducting layer 53 which is the structure body opposed to the jetty portion 56, and movement is made delay by the parasitic capacity Ci when the actuator element is operated.

For that reason in this embodiment shown in Fig. 9, the delay of movement by the parasitic capacity Ci is prevented when the semiconductor device is utilized as the actuator. In this example, the jetty portion 70 is formed as the laminated structure with an insulating layer 71 and a conducting layer 72. Further, an electrode pad 73 for the jetty portion is formed on the conducting layer 72 and inside of the outermost wall of the jetty portion 70, and the electrode pad 73 on the jetty portion 70 and the electrode pad 54 which is formed on the conducting layer 53 as the structure body, are connected by a conducting wire 74 as a potential equalizing means such that potential difference between the conducting layer 53 and the conducting layer 72 is made close to zero in order to have the same potential.

By making the conducting layer 53 and 72 equal potential as described above, because the parasitic capacity Ci which is generated between the conducting layer 72 of the jetty portion 70 and the side surface of the conducting layer 53 which is opposed to the jetty portion, does not function as a capacitor, the adverse effect such as the delay of movement can be excluded.

Moreover, because the electrode pad 73 which is formed on the jetty portion 70, is arranged inside of the outer wall of the jetty portion 70, and the protecting tape 9 is adhered closely on the substrate 51 as shown in Fig. 3, the possibility can be cleared that the electrode pad 73 is damaged when the dicing process is performed on the substrate 51.

Fig. 10 is a cross sectional view to show a semiconductor device according to an eighth embodiment of the present invention.

In case that the semiconductor device shown in Fig. 1 is utilized as a capacity type detecting sensor, the sensor detects the capacitance obtained when the parasitic capacity Ci that arises between the jetty portion 56 and the side surface of the conducting layer 53 opposed to the jetty portion, and sum of capacity C and capacity change ΔC that arise between the conducting layer 53 and the substrate 51, are connected in parallel. The parasitic capacity Ci functions as a capacitor and the parasitic capacity Ci becomes a factor to cause degradation of sensitivity and aggravation of input conversion noise level.

To clear the above described problem, a sensor according to this embodiment of the present invention excludes the adverse effect by the parasitic capacity Ci when the sensor is utilized as the capacity type detecting sensor. In this example, as the sensor shown in Fig. 9, the jetty portion 70 is formed as the laminated structure with the insulating layer 71 and the conducting layer 72. An electrode pad 73 for the jetty portion is formed on the conducting layer 72 and inside of the outer wall of the jetty portion 70, and a capacity type sensor detecting circuit 75 is connected between the electrode pad 73 and the electrode pad 54 which is formed on the conducting layer 53. The capacity type sensor detecting circuit 75 is constituted by a voltage follower circuit in which one input of an operational amplifier is connected to the electrode pad 54 of the conducting layer 53 and another input of the operational amplifier and an output of the operational amplifier are connected together. An output of the voltage follower circuit is connected to the electrode pad 73 of the jetty portion 70, and at the same time the output is connected to an output terminal 76. Biasing voltage is input to the electrode pad 55 on the substrate 51 though the biasing voltage is not shown in the drawing.

Because a voltage follower circuit has gain of 1, the potential difference between the conducting layers 53 and 73 can be brought close to zero by making them substantially the equal potential equivalently. As a result of this, because the effect of the parasitic capacity Ci to the detected capacity is cancelled in appearance and only sum of capacity C and amount of the capacity change ΔC generated between the conducting layer 53 and the substrate 51 is detected by the capacity type sensor detecting circuit 75, the sensor can improve the sensitivity and at the same time can reduce the input conversion noise level.

At this point, the capacity type sensor detecting circuit 75 is not restricted to the voltage follower circuit and any other circuit may be utilized as far as the circuit can make the conducting layer 53 and 72 have substantially the equal potential.

Further, the embodiments shown in Fig. 9 and Fig. 10 can be applied not only to the semiconductor device shown in Fig. 1, but also to the semiconductor devices shown in Fig. 4 to Fig. 8.

Fig. 11 is a plan view to show a semiconductor device according to a ninth embodiment of the present invention. In this embodiment, a circular shape conducting layer 53 and the conducting layer 72 of the jetty portion 72 are configured to be integrated. By such arrangement that the conducting layer 53 and the conducting layer 72 are made integrated, the conducting wire 74 can be omitted.

Fig. 12 (A) to Fig. 12 (E) are diagrams to sequentially show a manufacturing process for the semiconductor devices shown in Fig. 9 and Fig. 10. At first, a substrate 201 shown in Fig. 12 (A) is prepared, and an insulating layer 202 is formed on the substrate 201 as shown in Fig. 12 (B), then a conducting layer 203 is formed on the insulating layer 202 as shown in Fig. 12 (C). By this conducting layer 203, the conducting layer 53 as the structure body and the conducting layer 72 of the jetty portion 70 shown in Fig. 9 and Fig. 10, are formed. Photo resist is coated on the conducting layer 203, and a resist pattern is formed by removing unnecessary portions utilizing photolithography technology. The conducting layer 53 and the conducting layer 72 of the jetty portion 70 as shown in Fig. 12 (D) are formed by etching utilizing the resist pattern as a mask. The space 57 is formed between the conducting layer 53 and the substrate 201 as shown in Fig. 12 (E) by a predetermined etching which is performed on the insulating layer 202. Then, by the remaining insulating layer 202 after this etching at a part of the outer periphery of the conducting layer 53, the fixing portion 52 and the insulating layer 71 for the jetty portion 70 which surrounds the conducting layer 53, are formed. At this point, the substrate 201 corresponds to the substrate 51 shown in Fig. 9 and Fig. 10.

As described above, the conducting layer 72 for the jetty portion 70 can be made out of the same material and the same process as the conducting layer 53, and the insulating layer 71 for the jetty portion 70 can be made out of the same material and the same process as the fixing portion 52. As a result of this, because no new material is required to use for making the jetty portion 70, and no new process is required to add, production cost for the semiconductor is not increased by adding the jetty portion 70 with the laminated structure.

Up to here, though the embodiments of the present invention have been explained with reference to the drawings, the present invention is not restricted only to the above illustrated embodiments. Various kinds of modifications and variations may be added to the illustrated embodiments within the same or equivalent scope of the present invention.

### INDUSTRIAL APPLICABILITY

The semiconductor device in accordance with the present invention is made without causing the breakage of the structure body of the element because the semiconductors are formed by the dicing process with preventing the foreign object from intruding into the space between the substrate and the conducting layer. As a result, the semiconductor device is effectively utilized as the actuator element and the capacity type detecting sensor.

## Claims

1. A semiconductor device cut into respective chips by a dicing process, comprising:
a substrate having an edge along a dicing line;
a semiconductor element formed on said substrate;
a jetty portion formed between said semiconductor element and said edge on said substrate; and
an electrode pad for signal input and output which is formed on said substrate, and inside of the outermost wall of said jetty portion.

2. The semiconductor device according to claim 1, wherein said jetty portion continuously extends along said edge in parallel.

3. The semiconductor device according to claim 1, wherein said jetty portion is formed so as to surround periphery of said semiconductor element.

4. The semiconductor device according to claim 1, wherein
said semiconductor element includes an insulating layer and a conducting layer formed on said insulating layer;
said jetty portion includes an insulating layer and a conducting layer formed on said insulating layer;
said insulating layer of said semiconductor element and said insulating layer of said jetty portion are formed in the same process; and
said conducting layer of said semiconductor element and said conducting layer of said jetty portion are formed in the same process.

5. The semiconductor device according to claim 4, wherein said electrode pad for signal input and output is formed on said conducting layer of said semiconductor element and said semiconductor device further comprising an electrode pad for said jetty portion which is formed inside of said outermost wall on said conducting layer of the jetty portion, and which is connected electrically to said electrode pad for signal input and output in order to make potential difference between said conducting layer of said jetty portion and said conducting layer of said semiconductor element close to zero.

6. A semiconductor device comprising:
a substrate;
a structure body supported by a fixing portion so as to form a space between said substrate and said structure body; and
a jetty portion formed on said substrate between the outer periphery of said substrate and a portion of said structure body which is not supported by said fixing portion.

7. The semiconductor device according to claim 6, wherein a plurality of said jetty portions are formed so as to surround the outer periphery of said structure body.

8. The semiconductor device according to claim 6 further comprising an electrode pad for signal input and output which is formed on said structure body and inside of the outermost wall of said jetty portion.

9. The semiconductor device according to claim 8, wherein a plurality of said jetty portions are formed so as to surround said structure body and said electrode pad for signal input and output is arranged inside of an imaginary outer periphery which is formed by connecting the outermost walls of said jetty portions.

10. The semiconductor device according to claim 6, wherein
said structure body includes a conducting layer formed on said fixing portion;
said jetty portion includes an insulating layer and a conducting layer formed on said insulating layer;
said fixing portion of said structure body and said insulating layer of said jetty portion are formed in the same process; and
said conducting layer of said structure body and said conducting layer of said jetty portion are formed in the same process.

11. The semiconductor device according to claim 10, wherein said electrode pad for signal input and output is formed on said conducting layer of said structure body and said semiconductor device further comprising an electrode pad for said jetty portion which is formed on said conducting layer of the jetty portion, and which is connected electrically to said electrode pad for signal input and output in order to make potential difference between said conducting layer of said jetty portion and said conducting layer of said structure body close to zero.

12. The semiconductor device according to claim 10 further comprising a potential equalizing means in order to make potential difference between said conducting layer of said jetty portion and said conducting layer of said structure body close to zero.

13. The semiconductor device according to claim 11 further comprising an impedance detecting means which is connected to said electrode pad for signal input and output to detect impedance change between said structure body and said substrate.

14. The semiconductor device according to claim 1, wherein an upper portion of inside area of said jetty portion is opened.
